# EUROPEAN PATENT SPECIFICATION

(11) **EP 1 696 443 B1**
(45) Date of publication and mention of the grant of the patent: **03.07.2013**
(21) Application number: 04807305.0
(22) Date of filing: 17.12.2004
(51) Int. Cl.: H01B 13/00, B05D 3/02, B05D 5/12, C09D 5/24

(54) **METHOD FOR FORMING TRANSPARENT CONDUCTIVE FILM AND TRANSPARENT ELECTRODE**
VERFAHREN ZUR HERSTELLUNG EINES TRANSPARENTEN LEITFÄHIGEN FILMS UND EINER TRANSPARENTEN ELEKTRODE
METHODE POUR FORMER UN FILM CONDUCTEUR TRANSPARENT ET ELECTRODE TRANSPARENTE

(30) Priority: 17.12.2003 JP 2003418897
(43) Date of publication of application: 30.08.2006
(73) Proprietor: ULVAC, INC., Chigasaki-shi, Kanagawa 253-8543 (JP)
(72) Inventor: UKISHIMA, Sadayuki c/o ULVAC, Inc., Sanbu-Gun, Chiba 2891226 (JP); TAKEI, Hideo c/o ULVAC, Inc., Sanbu-Gun, Chiba 2891226 (JP); ISHIBASHI, Satoru c/o ULVAC, Inc., Sanbu-Gun, Chiba 2891226 (JP); ATSUKI, Tsutomu, Sanbu-Gun, Chiba 2891226 (JP); ODA, Masaaki, Sanbu-Gun, Chiba 2891226 (JP); YAMAGUCHI, Hiroshi, Sanbu-Gun, Chiba 2891226 (JP)
(74) Representative: Störzbach, Michael Andreas
(86) International application number: PCT/JP2004/018948
(87) International publication number: WO 2005/059927

(56) References cited:
- JP-A- 2001 106 567
- JP-A- 2003 249 126
- JP-A- 2003 249 131
- JP-A- 2003 249 132
- US-A- 4 842 705
- US-A1- 2003 224 162

## Description

### Technical Field

The present invention relates to a method for the formation of a transparent conductive film and a transparent electrode and, more particularly, to a method for the formation of a transparent conductive film using fine metal particles or fine alloy particles, which may be used in the fields of, for instance, electric and electronic industries as well as a transparent electrode being composed of the resulting transparent conductive film.

### Background Art

There have in general been used transparent conductive films each composed of, for instance, ITO or ATO as the electrode for a flat panel display device typical of a liquid crystal display device. Examples of methods for the preparation of such a transparent conductive film are the evaporation technique, the ion-plating technique and the sputtering technique and such a film is formed by the adhesion of a metal oxide film to the surface of a glass substrate. Presently, it would be more common that an ITO film as an oxide film is formed by the sputtering technique.

In addition, there has been known a method comprising the steps of preparing a dispersion of tin-doped indium oxide powder; applying the resulting dispersion onto the surface of a substrate; drying the applied layer of the dispersion; and then firing the same to thus give a transparent conductive film used as an antistatic film or a film for forming an electrode and/or a circuit (see, for instance, the patent reference 1 as specified later). In the method disclosed in this patent reference 1, an oxide film is directly formed on the surface of a transparent substrate such as a glass substrate, but the resulting transparent conductive film should be fired at a temperature ranging from 200 to 900°C (in the Example, the firing is carried out at 400°C) after the formation of a film on the transparent substrate in order to use the same in the flat panel display device typical of the liquid crystal and plasma display devices. Moreover, the size of a display device will increasingly be large and it would become one of the mainstreams to fabricate such a display device using an acrylic substrate. For this reason, such a film-forming technique which requires a treatment at a high temperature on the order of 400°C suffers from such a problem that the substrate would be impaired or damaged because of the limit in the heat resistance of the substrate.

As a means for solving the above-mentioned problem, there has been known a method which makes use of metal particles of a nano size and comprises the steps of coating a dispersion of the nanoparticles, drying the coated layer thereof and firing the same to thus give an ITO or ATO film in the case of the preparation of a transparent electrode for display devices and which would permit the formation of a transparent conductive film having a quite large area while substantially reducing the production cost (see, for instance, the patent reference 2 as specified later).

There has also been known such a method comprising forming, at a relatively low temperature, a transparent conductive film having a low electric resistance on a substrate such as a transparent plastic film using metallic ultrafine particles such as ultrafine particles of Ag (see, for instance, the patent reference 3 as specified later). As will be seen from this patent reference 3, the use of Ag would permit the reduction of the electric resistance of the resulting film, but this technique suffers from such a problem that the ultrafine particles of Ag are pigmented through the plasmon absorption and that it would in turn be quite difficult to obtain a film having a satisfactorily high light-transmittancc.

In addition, there has also been known another method for preparing an antistatic film using transparent oxide particles having a low electric resistance, in which the contact between these particles can ensure the desired conductivity of the resulting film. In this case, the following method is adopted to achieve a more compact packing condition of these particles. More specifically, a transparent conductive film is formed on the surface of a substrate and then a second film is applied onto the first film to thus improve the adhesive force acting between these particles and to reduce the contact resistance while making use of the thermal shrinkage of the second film, and to in turn reduce the surface resistance of the resulting film. However, this technique may suffer from a problem such that it requires the use of quite complicated processes.
Patent Reference 1: Japanese Un-Examined Patent Publication Hei 07-242842 (Claims and Examples);
Patent Reference 2: Japanese Un-Examined Patent Publication 2003-249131 (Claims);
Patent Reference 3: Japanese Un-Examined Patent Publication 2001-176339 (Claims).

US 2003/224162 discloses a method for producing a transparent conductive film comprising a step of applying, onto a base material, a dispersion containing nanoparticles of In/Sn, In/Zn, Zn/Sn, Sb/Sn to form a layer, a drying step and a baking step wherein the particles are oxidised during at least one of the coating step, drying step and baking step.

US 4 842 705 A discloses a vapour deposition method wherein the oxygen content in the atmosphere is controlled in order to achieve optimum transparency and resistivity of the sheet. The method consists in maintaining a low oxygen partial pressure during the electron beam deposition of the coating and thereafter heating in an oxygen atmosphere.

### Disclosure of the Invention

### Problems That the Invention is to Solve

It is an object of the present invention to solve the foregoing problems associated with the aforementioned conventional techniques and more specifically to provide a method for forming a transparent conductive film having a high light-transmittance and a low electric resistance by using metal fine particles or alloy fine particles and firing the particles at a low temperature as well as a transparent electrode being composed of this transparent conductive film.

### Means for the Solution of the Problems

The method for the formation of a transparent conductive film according to the present invention is characterized in that it comprises the steps of applying, onto a base material, a dispersion containing fine particles of at least one metal selected from the group consisting of indium, tin, antimony, aluminum and zinc, fine particles of at least one alloy consisting of at least two metals selected from the group specified above or a mixture of these fine particles; firing the coated layer in an atmosphere which never undergoes any oxidation of the foregoing metal and/or alloy; and subsequently firing the layer in an oxidizing atmosphere to thus form a transparent conductive film. In this respect, the mixture of fine particles is one comprising metal fine particles and alloy fine particles. Such a two-stage process would permit the formation of a transparent conductive film having a high light-transmittance and a low electric resistance, while making use of a firing step carried out at a low temperature.

An embodiment of the method of the present invention is characterized in that the non-oxidizing atmosphere is one selected from the group consisting of a vacuum atmosphere, an inert gas atmosphere and a reducing atmosphere.

Another embodiment of the method of the present invention is characterized in that it further comprises the step of firing the coated layer in a reducing atmosphere after the firing step carried out in the oxidizing atmosphere.

A further embodiment of the method of the present invention is characterized in that the inert gas atmosphere is one comprising at least one inert gas selected from the group consisting of rare gases, carbon dioxide gas and nitrogen gas and the reducing atmosphere is one comprising at least one reducing gas selected from the group consisting of hydrogen gas, carbon monoxide gas and gases of lower alcohols.

A still further embodiment of the method of the present invention is characterized in that the vacuum atmosphere comprises at least one inert gas selected from the group consisting of rare gases, carbon dioxide gas and nitrogen gas; at least one oxidizing gas selected from the group consisting of oxygen gas and water vapor; at least one reducing gas selected from the group consisting of hydrogen gas, carbon monoxide gas and gases of lower alcohols; or a mixed gas comprising the inert gas and the oxidizing gas or the reducing gas.

A still another embodiment of the method of the present invention is characterized in that the oxidizing atmosphere comprises oxygen gas, water vapor, oxygen-containing gases (such as the air) or water vapor-containing gases.

A further embodiment of the method of the present invention is characterized in that the metal fine particles and/or the alloy fine particles are those each comprising an organic compound adhered to the surroundings, thereof. This would permit the improvement of the dispersibility of these fine particles.

The transparent electrode according to the present invention is composed of the transparent conductive film prepared by the foregoing method.

According to an embodiment of the present invention, the temperature used in the firing steps carried out in the foregoing non-oxidizing atmosphere and in the oxidizing atmosphere is preferably in the heat resistant tolerance limit of not less than the melting point of the metal fine particles or the alloy fine particles and less than the softening point of the base material. More specifically, this firing temperature is more preferably not more than 300°C. If the firing temperature falls within the range specified above, the base material is never damaged during the firing steps.

Moreover, the particle size of the foregoing metal fine particles and alloy fine particles preferably ranges from 0.5 nm to 50 nm. This is because if the particle size thereof is less than 0.5 nm, the substantial surface area of the particles increases and the amount of the organic substances adhered to the surroundings thereof correspondingly increases. This not only leads to an increase of the time required for the firing step, but also makes the formation of cracks easy through the thermal shrinkage. On the other hand, if it exceeds 50 nm, the particles are liable to undergo settling or sedimentation when they are dispersed in an organic solvent.

### Effects of the Invention

According to the method of the present invention, specific metal fine particles and/or alloy fine particles are first subjected to a low temperature firing treatment in a non-oxidizing atmosphere and they are then subjected to a separate low temperature firing treatment in an oxidizing atmosphere. Accordingly, the method of the present invention would permit not only the formation of a transparent conductive film having excellent characteristics such as a low electric resistance and a high light-transmittance at a low temperature, but also the preparation of an excellent transparent electrode being composed of the transparent conductive film.

### Best Mode for Carrying Out the Invention

In the following description, the term "metal fine particles" used herein means that the fine particles also include alloy fine particles,'unless otherwise specified.

As has already been discussed above, the method according to the present invention comprises the steps of applying, onto a base material to be treated, a dispersion containing fine particles of at least one constituent metal of the metal oxide used for forming a transparent conductive film (such as indium, tin, antimony, aluminum and zinc), fine particles of at least one alloy consisting of at least two metals selected from the group consisting of the foregoing constituent metal components or a mixture of the foregoing metal fine particles and the foregoing alloy fine particles, according to any known coating method; and then firing the coated layer in an atmosphere, which never causes any oxidation of the foregoing metal and/or alloy, such as a vacuum atmosphere, an inert gas atmosphere or a reducing atmosphere. In the case of the vacuum atmosphere, the introduction of an oxidizing gas may have such an effect that it can oxidize or burn only the organic substance adhered to the fine particles without causing any oxidation of the metal and/or alloy. Subsequently, the fine particles are fired in an oxidizing atmosphere. At this stage, it is also possible to dry the base material provided thereon with the coated layer of the dispersion at a desired temperature prior to the first firing step in order to remove the dispersing medium or the like. The removal of the dispersing medium may likewise be carried out during the firing process.

According to the method of the present invention, a desired transparent conductive film is formed by carrying out the foregoing two firing processes at a temperature (for instance, not more than 300°C) lower than that (in general, ranging from 400 to 700°C) required for firing the metal oxide fine particles per se as a usual material for forming a transparent conductive film. As has been described above, the metal fine particles used in the present invention would permit the formation of a compact film at a temperature lower than that used in the formation of a metal oxide film and therefore, the method of the invention not only permit the preparation of a transparent conductive film having a low electric resistance at a low firing temperature, but also the improvement of the light-transmittance or light-transmitting properties in the case of the firing carried out in an oxidizing atmosphere. Moreover, in the foregoing two firing processes, the irradiation of the coated layer with light rays emitted from a UV lamp would permit the achievement of further effects such as the saving of the time required for the processes and the further reduction of the firing temperature. In addition, it is also effective to use a method which makes use of the known atmospheric plasma in the firing process according to the present invention.

As metal oxides used in the present invention for forming a transparent conductive film include, for instance, ITO (In-Sn-O) (wherein 0% by mass ≤ Sn ≤ 20% by mass, preferably 3% by mass ≤ Sn ≤ 10% by mass), ATO (Sn-Sb-O) (wherein 0% by mass ≤ Sb ≤ 20% by mass, preferably 5% by mass ≤ Sb ≤ 15% by mass), AZO (Zn-Al-O) (wherein 0% by mass ≤ Al ≤ 20% by mass, preferably 5% by mass ≤ Al ≤ 15% by mass), and IZO (In-Zn-O) (wherein 0% by mass ≤ Zn ≤ 20% by mass, preferably 5% by mass ≤ Zn ≤ 15% by mass).

The base material usable in the method for the formation of a transparent conductive film according to the present invention is not restricted to any specific one inasmuch as it is a transparent base material and specific examples thereof include organic resin materials which require the use of a firing step carried out at a low temperature such as acrylic base materials, polyimide base materials and polyethylene terephthalate (PET) films; and glass electrodes each provided thereon with an organic film such as an organic color filter. Examples of such organic resin materials also include, in addition to the foregoing ones, cellulose acetates, polystyrene, polystyrenes, polyethers, polyimides, epoxy resins, phenoxy resins, polycarbonates, poly(vinylidene fluorides), and Teflon (registered trade mark). They may be used alone or as a mixture or laminate of at least two of them combined together, as a base material used herein. The shape of the base material is not restricted to any specific one and specific examples thereof include a flat plate-like shape, a three-dimensional shape or a film. In this connection, the base material to be processed is preferably washed, for instance, using pure water or by the application of ultrasonics, prior to the application of the foregoing dispersion.

Examples of methods for the application of the dispersion onto the base material used in the present invention include the spin coating method, the spray coating method, the ink jet coating method, the dip coating method, the roll coating method, the screen printing method and the contact printing method. The coating method may be a single coating technique or a double (or more) coating technique inasmuch as the method permits the formation of a film having a desired thickness.

As has been discussed above, the coated film is first fired in an atmosphere, which does not cause any oxidation of the metal fine particles, such as a vacuum atmosphere, an inert gas atmosphere or a reducing atmosphere, according to the method of the present invention. In this case, the vacuum atmosphere can be established in the treating system by simply exhausting the same with a pump, or by once exhausting the system with a pump and then introducing an inert gas, a reducing gas or an oxidizing gas into the system. The firing in the vacuum atmosphere can in general be carried out at a pressure on the order of about 10⁻⁵ to 10³ Pa.

According to the method of the present invention, the metal fine particles are fired in a reducing atmosphere as an atmosphere which is completely free of any oxidation of the metal fine particles. Examples of lower alcohols which may be used in this firing step include those having 1 to 6 carbon atoms such as methyl alcohol, ethyl alcohol, propyl alcohol, butyl alcohol and hexyl alcohol.

The method for the preparation of the metal fine particles and the alloy fine particles is not limited to any specific one and these fine particles may be prepared by, for instance, the gas phase-evaporation technique (or the evaporation-in-gas technique), the wet reducing technique, or a heat-reduction technique in which an organometallic compound is injected or atomized into a high temperature atmosphere.

The resulting metal fine particles and alloy fine particles preferably have metallic surface, but these fine particles may have such a metallic surface which is in an at least partially oxidized condition.

The gas phase-evaporation technique among the foregoing fine particle-production methods is one in which a metal is evaporated in a gas phase or a gas atmosphere in the co-existence of the vapor of a solvent so that the evaporated metal condensates into uniform ultrafine particles and that the resulting particles are dispersed in the solvent to thus give a desired dispersion (see, for instance, Japanese Patent No. 2,561,537). This gas phase-evaporation technique would permit the preparation of metal ultrafine particles having a uniform particle size on the order of not more than 50 nm. To make such metal fine particles, as a raw material, suitable for use in a variety of applications, it would be sufficient to carry out substitution with an organic solvent in the final step. Furthermore, to improve the dispersion stability of these fine particles, it is sufficient to add a dispersant to the particles in any desired step. Thus, the metal fine particles are independently and uniformly dispersed and they can maintain their condition rich in the flow ability.

The foregoing organic solvent may appropriately be selected while taking into consideration of the kinds of metal fine particles used. Examples thereof include organic solvents which are in the liquid states at ordinary temperature, for instance, alcohols such as methanol, ethanol, propanol, isopropyl alcohol, butanol, hexanol, heptanol, octanol, decanol, cyclohexanol, and terpineol; glycols such as ethylene glycol and propylene glycol; ketones such as acetone, methyl ethyl ketone and diethyl ketone; esters such as ethyl acetate, butyl acetate and benzyl acetate; ether alcohols such as methoxy ethanol and ethoxy ethanol; ethers such as dioxane and tetrahydrofuran; acid amides such as N,N-dimethylformamide; aromatic hydrocarbons such as benzene, tolucne, xylene, trimethyl benzene and dodecyl benzene; long chain alkanes such as hexane, heptane, octane, nonane, decane, undecane, dodecane, tridecane, tetradecane, pentadecane, hexadecane, octadecane, nonadecane, eicosane and trimethyl pentane; and cyclic alkanes such as cyclohexane, cycloheptane and cyclooctane, which may appropriately be selected and then practically used. In addition, the term: organic solvent herein used is so defined as to also include water.

Moreover, the metal fine particles prepared according to the gas phase-evaporation technique may be dispersed in an organic solvent selected from those specified above, but preferably used herein include non-polar solvents such as toluene, xylene, benzene and tetradecane; ketones such as acetone and ethyl ketone; and alcohols such as methanol, ethanol, propanol and butanol. In this respect, when preparing an ink liquid for the ink-jet recording, a proper solvent should be selected while taking into consideration of the compatibility with the materials for the head (including the surface-coating material) (for instance, the solvent has physical properties such as those which never take part in the corrosion and the dissolution of the head materials), the ability of causing any agglomeration of the metal fine particles in the head as well as the ability thereof to cause any clogging of the head.

The foregoing organic solvents may be used alone or in any combination (mixed solvent). For instance, the organic solvent may be a mineral spirit which is a mixture of long chain alkanes.

The amount of the foregoing solvent to be used may vary depending on the kinds of metal fine particles used and the applications thereof and may thus appropriately be set at a level which would improve the coating properties and which can ensure a desired thickness of the resulting film. For instance, the solvent may be used in an amount sufficient for obtaining a dispersion having a concentration of metal fine particles ranging from 1 to 70% by mass and the concentration of the metal fine particles may, at any time, be adjusted by, for instance, heating in a vacuum even after the preparation of a dispersion.

Moreover, the metal and alloy fine particles used in the present invention may be those each surrounded by an organic compound adhered thereto as has been discussed above. The dispersion of metal fine particles prepared according to the gas phase-evaporation technique is one prepared by separately or independently dispersing metal fine particles having a particle size of not more than 50 nm in an organic solvent using at least one member selected from the group consisting of alkylamines, carboxylic acid amides and amino-carboxylic acid salts as a dispersant. In such a dispersion, each of the metal fine particles is in such a condition that it is surrounded by an organic compound adhered thereto as a dispersant and the use of such fine particles would make it easy to prepare a dispersion thereof.

The foregoing alkylamine used as a dispersant may be a primary, secondary or tertiary amine; or a monoamine, a diamine or a triamine. Preferably used herein are alkylamines whose principal chain has 4 to 20 carbon atoms and more preferably alkylamines whose principal chain has 8 to 18 carbon atoms from the viewpoint of their stability and handling characteristic. In this respect, if the carbon atom number of the principal chain thereof is smaller than 4, problems arise, for instance, the basicity of the amine is apt to be so high that it may corrode the metal fine particles and it may finally dissolve the fine particles. On the other hand, if the carbon atom number of the principal chain is larger than 20, problems likewise arise such that when increasing the concentration of the dispersion of the metal fine particles, the viscosity of the resulting dispersion correspondingly increases and this in turn leads to the slight deterioration of handling characteristics; and that there is such a tendency that carbon easily remains in the film obtained after firing step and this may accordingly leads to an increase of the specific resistance (resistivity). In addition, all kinds of alkylamines (or primary, secondary and tertiary alkylamines) may efficiently serve as dispersants, but preferred are primary alkylamines because of their stability and handling characteristics.

Specific examples of alkylamines are primary alkylamines such as butylamine, octyl amine, dodecyl amine, hexadodecyl amine, octadecyl amine, cocoamine, tallow amine, hydrogenated tallow amine, oleyl amine, lauryl amine, and stearyl amine; secondary amines such as dicocoamine, dihydrogenated tallow amine and distearyl amine; tertiary amines such as dodecyl dimethyl amine, didodecyl monomethyl amine, tetradecyl dimethyl amine, octadecyl dimethyl amine, cocodimethyl amine, dodecyl tctradecyl methyl amine and trioctyl amine; and other diamines such as naphthalene diamine, stearyl propylene diamine, octamethylcne diamine and nonane diamine.

Specific examples of the foregoing carboxylic acid amides and amino carboxylic acid salts are stearic acid amide, palmitic acid amide, lauric acid laurylamide, oleic acid amide, oleic acid diethanol amide, oleic acid laurylamide, stearanilide and oleylamino-ethyl glycine.

Alternatively, the metal fine particles used in the present invention may likewise be those prepared according to the chemical reduction method such as the liquid phase-reduction method and when preparing a dispersion, a raw material for reduction, which is a metal-containing organic compound, may be used as a raw material for preparing metal fine particles.

This chemical reduction method is one for preparing a metal fine particle-containing dispersion through a chemical reaction using a reducing agent and in the case of the fine particles prepared according to this reduction method, the particle size thereof can arbitrarily be adjusted to a level of not more than 50 nm. This reduction method is, for instance, carried out as follows: A raw material is decomposed by heating the same to a desired temperature while adding a dispersant to the raw material; or metal fine particles are generated while making use of a reducing agent such as hydrogen gas or sodium borohydride. Almost all of the metal fine particles thus obtained are recovered in the independently dispersed condition. The particle size of the metal fine particles is not more than about 50 nm. A desired dispersion of the metal fine particles can be obtained by substituting an organic solvent listed above for the solvent of the resulting dispersion of the metal fine particles. The resulting dispersion would maintain its stable dispersion state even when it is concentrated through heating in a vacuum.

The transparent conductive film formed according to the foregoing transparent conductive film-forming method of the present invention may be used as, for instance, a transparent electrode for planar display devices, a transparent antistatic film, a transparent electromagnetic wave-shielding film, a planar heat-generating element, a transparent electrode antenna, a solar cell, an electrode for electronic paper and a transparent electrode type gas sensor.

The method for the preparation of metal fine particles will hereunder be described in more detail.

### (Preparation Example 1)

In-Sn alloy fine particles containing 6% by mass of Sn were produced as follows according to the gas phase-evaporation technique which made use of the high frequency induction heating under a helium gas pressure of 0.5 Torr: the In-Sn alloy fine particles were brought into close contact with the vapor of a 20:1 (volume ratio) mixture of α-terpineol and dodecylamine, followed by cooling the system and collecting the resulting In-Sn alloy fine particles to thus give a dispersion containing In-Sn alloy fine particles having an average particle size of 10 nm and independently dispersed in the α-terpineol solvent in a concentration of 20% by mass. To one volume of this dispersion (a colloid solution), there were added 5 volumes of acetone and the resulting mixture was then stirred. The fine particles dispersed in the dispersion underwent sedimentation due to the action of acetone as a polar solvent. After allowing the system to stand for 2 hours, the supernatant was removed, followed by the addition of the same volume of acetone initially used to the precipitates, stirring the resulting mixture, allowing the mixture to stand over 2 hours and then the removal of the supernatant. The remaining solvent was completely removed from the resulting precipitates to thus obtain In-Sn alloy fine particles having an average particle size of 10 nm.

Fine particles of the foregoing metals or alloys other than In, Sn or those containing In, Sn can likewise be prepared according to the same production method used above.

### Example 1

The metal fine particles used in this Example were the In-Sn alloy fine particles prepared in Preparation Example 1 according to the gas phase-evaporation technique. These particles were found to have an average particle size of 10 nm and it was also confirmed by the X-ray diffraction analysis that they were non-oxidized alloy fine particles. Moreover, the content of Sn in the alloy fine particles was found to be 6% by mass as determined by the X-ray fluorescence spectroscopic analysis.

The fine particles were dispersed in an organic solvent (toluene) in a concentration of 10% by mass and the resulting dispersion was then applied onto the surface of a glass substrate according to the spin coating method. Subsequently, the coated film was fired under the following conditions: a reduced pressure of 1×10⁻³ Pa; a firing temperature of 230°C; and a firing time of 10 minutes. Then the coated film was further fired at 230°C over 60 minutes in an oxidizing atmosphere (in the air atmosphere). The resulting transparent conductive film was found to be in a sufficiently densified condition and it was further found that the surface resistance thereof was 60 Ω/□ and a transmittance, as determined at 550 nm, of 92%. At this stage, the thickness of the film was found to be 200 nm. In this case, when the film was further fired in a hydrogen gas-containing atmosphere and in a carbon monoxide-containing atmosphere after the firing in the oxidizing atmosphere, the resulting transparent conductive film had a further reduced surface resistance. In other words, the film was further improved in the quality by the additional firing steps.

The transparent conductive film produced in Example 1 was found to be useful as a transparent electrode for display machinery and tools.

### (Comparative Example 1)

The dispersion of metal fine particles prepared in Example 1 was applied onto the surface of a glass substrate by the method similar to that used in Example 1. Then the coated film was fired at 250°C over 60 minute in the air atmosphere. The resulting transparent conductive film was found to be in an insufficiently densified state and it was also found that the film had a surface resistance of 5.3×10⁵ Ω/□ and a transmittance of 93%. As will be clear from the foregoing results, when all of the firing steps were carried out in the air atmosphere, the resulting film had a sufficiently high light-transmittance, but the surface resistance thereof was extremely high and accordingly, the resulting film was not effective for use as a transparent electrode.

From the foregoing, it was found to be effective to first carry out the firing step in an atmosphere which is free of any oxidation of a metal or an alloy or a vacuum atmosphere for the purpose of the formation of a transparent conductive film having a low surface resistance and a high light-transmittance. The reason of this would be considered to be as follows: If a coated film is first treated in a vacuum atmosphere, the treatment does not undergo any oxidation of In-Sn alloy fine particles at all, but permits the decomposition and/or evaporation of a dispersant and/or an organic substance such as a hydrocarbon which protects the metal fine particles and accordingly, this treatment would accelerate the association of alloy fine particles to thus form compact or densified transparent conductive film. For this reason, it would be considered that the uptake of oxygen in the film is considerably restricted even in the subsequent firing steps carried out in the air and therefore, the electrical resistance of the film is not deteriorated.

### (Comparative Example 2)

Various kinds of In-Sn alloy fine particles were produced according to the gas phase-evaporation technique while making use of wide variety of evaporation conditions. Among these various kinds of alloy fine particles prepared under such wide variety of evaporation conditions, those having an average particle size of about 70 nm were selected and the procedures similar to those used in Example 1 were repeated or the selected metal fine particles were dispersed in an organic solvent (toluene) in a concentration of 10% by mass to thus give each corresponding dispersion. As a result, it was confirmed that these dispersions underwent sedimentation when allowing them to stand for a while (about 3 hours). Thus, they were unstable and were accordingly impracticable.

As Examples other than the foregoing, which made use of metal fine particles or alloy fine particles of every metal components constituting the metal oxides used for the formation of the foregoing transparent conductive films, the procedures similar to those used in the foregoing Example were repeated or the low temperature firing processes were used for preparing transparent conductive films each having a low surface resistance and a high light-transmittance. The results thus obtained are summarized in the following Table 1. Table 1 also includes the results obtained in Comparative Examples.

**Table 1**

| Ex. No. | Materials used | 1^{st} Anneal: vacuum, Inert Gas, Reducing Atm. | | | | 2^{nd} Anneal: Oxidizing Atm. | | |
|---|---|---|---|---|---|---|---|---|
| | | Tem. (°C) | Pr. (Pa) | Atm. | Time min. | Tem. (°C) | Pr. (Pa) | |
| 2 | In | 250 | 667 | Only Evac. | 30 | 250 | 667 | |
| 3 | In | 230 | 8.80E-02 | Only Evac. | 30 | 230 | 667 | |
| 4 | In | 250 | 8.80E-02 | Only Evac. | 30 | 200 | Atm. Pr. | |
| 5 | In-Sn, 6wt% Sn | 230 | 1.00E-03 | Only Evac. | 10 | 230 | Atm. Pr. | |
| 6 | In-Sn, 6wt% Sn | 230 | 1.00E-03 | Only Evac. | 10 | 230 | Atm. Pr. | |
| 7 | In-Sn, 6wt% Sn | 230 | 1.00E-03 | Only Evac. | 5 | 230 | Atm. Pr. | |
| 8 | In-Sn, 6wt% Sn | 230 | 1.00E-03 | Only Evac. | 5 | 230 | Atm. Pr. | |
| 9 | In-Sn, 6wt% Sn | 230 | 8.2 | Only Evac. | 10 | 230 | Atm. Pr. | |
| 10 | In-Sn, 6wt% Sn | 230 | 8.2 | Only Evac. | 10 | 230 | Atm. Pr. | |
| 11 | In-Sn, 6wt% Sn | 230 | Atm. Pr. | N₂ | 10 | 230 | Atm. Pr. | |
| 12 | In-Sn, 6wt% Sn | 230 | Atm. Pr. | N₂ | 30 | 230 | Atm. Pr. | |
| 13 | In-Sn, 6wt% Sn | 230 | 8.2 | Only Evac. | 10 | 230 | Atm. Pr. | |
| 14 | In-Sn, 6wt% Sn | 230 | Atm. Pr. | Argon | 10 | 230 | Atm. Pr. | |
| 15 | In-Sn, 6wt% Sn | 230 | Atm. Pr. | Helium | 10 | 230 | Atm. Pr. | |
| 16 | In-Sn, 6wt% Sn | 230 | 8.2 | Only Evac. | 10 | 230 | Atm. Pr. | |
| 17 | In-Sn, 6wt% Sn | 230 | Atm. Pr. | Argon | 10 | 230 | Atm. Pr. | |
| 18 | In-Sn, 6wt% Sn | 230 | Atm. Pr. | Helium | 10 | 230 | Atm. Pr. | |
| 19 | In-Zn, 6wt% Zn | 230 | 1.00E-03 | Only Evac. | 10 | 230 | Atm. Pr. | |
| 20 | In-Zn, 6wt% Zn | 230 | 1.00E-03 | Only Evac. | 10 | 230 | Atm. Pr. | |
| 21 | In-Zn, 6wt% Zn | 230 | 1.00E-03 | Only Evac. | 5 | 230 | Atm. Pr. | |
| 22 | In-Zn, 6wt% Zn | 230 | 1.00E-03 | Only Evac. | 5 | 230 | Atm. Pr. | |
| 23 | In-Zn, 6wt% Zn | 230 | 8.2 | Only Evac. | 10 | 230 | Atm. Pr. | |
| 24 | In-Zn, 6wt% Zn | 230 | 8.2 | Only Evac. | 10 | 230 | Atm. Pr. | |
| 25 | In-Zn, 6wt% Zn | 230 | Atm. Pr. | N₂ | 10 | 230 | Atm. Pr. | |
| 26 | In-Zn, 6wt% Zn | 230 | Atm. Pr. | N₂ | 30 | 230 | Atm. Pr. | |
| 27 | In-Zn, 6wt% Zn | 230 | 8.2 | Only Evac. | 10 | 230 | Atm. Pr. | |
| 28 | In-Zn, 6wt% Zn | 230 | Atm. Pr. | Argon | 10 | 230 | Atm. Pr. | |
| 29 | In-Zn, 6wt% Zn | 230 | Atm. Pr. | Helium | 10 | 230 | Atm. Pr. | |
| 30 | In-Zn, 6wt% Zn | 230 | 8.2 | Only Evac. | 10 | 230 | Atm. Pr. | |
| 31 | In-Zn, 6wt% Zn | 230 | Atm. Pr. | Argon | 10 | 230 | Atm. Pr. | |
| 32 | In-Zn, 6wt% Zn | 230 | Atm. Pr. | Helium | 10 | 230 | Atm. Pr. | |
| 33 | Sn-Sb, 5wt% Sb | 250 | 1.00E-03 | Only Evac. | 10 | 250 | Atm. Pr. | |
| 34 | Sn-Sb, 5wt% Sb | 250 | 1.00E-03 | Only Evac. | 10 | 250 | Atm. Pr. | |
| 35 | Sn-Sb, 5wt% Sb | 250 | 8.2 | Only Evac. | 10 | 250 | Atm. Pr. | |
| 36 | Sn-Sb, 5wt% Sb | 250 | 8.2 | Only Evac. | 10 | 250 | Atm. Pr. | |
| 37 | Sn-Sb, 5wt% Sb | 250 | 8.2 | Only Evac. | 10 | 250 | Atm. Pr. | |
| 38 | Sn-Sb, 5wt% Sb | 250 | Atm. Pr. | Argon | 10 | 250 | Atm. Pr. | |
| 39 | Sn-Sb, 5wt% Sb | 250 | Atm. Pr. | Argon | 10 | 250 | Atm. Pr. | |
| 40 | Zn-Al, 5wt% Al | 250 | 1.00E-03 | Only Evac. | 10 | 250 | Atm. Pr. | |
| 41 | Zn-Al, 5wt% Al | 250 | 1.00E-03 | Only Evac. | 10 | 250 | Atm. Pr. | |
| 42 | Zn-Al, 5wt% Al | 250 | 8.2 | Only Evac. | 10 | 250 | Atm. Pr. | |
| 43 | Zn-Al, 5wt% Al | 250 | 8.2 | Only Evac. | 10 | 250 | Atm. Pr. | |
| 44 | Zn-Al, 5wt% Al | 250 | 8.2 | Only Evac. | 10 | 250 | Atm. Pr. | |
| 45 | Zn-Al, 5wt% Al | 250 | Atm. Pr. | Argon | 10 | 250 | Atm. Pr. | |
| 46 | Zn-Al, 5wt% Al | 250 | Atm. Pr. | Argon | 10 | 250 | Atm. Pr. | |
| 3* | In | 230 | 1.00E-03 | Only Evac. | 10 | - | - | |
| 4* | In | 230 | Atm. Pr. | Oxygen | 10 | 250 | 1.00E-03 | |
| 5* | In-Sn, 6wt% Sn | 230 | Atm. Pr. | Oxygen | 10 | 250 | 1.00E-03 | |
| 6* | In-Sn, 6wt% Sn | 230 | Atm. Pr. | Atm. | 10 | - | - | |
| 7* | Sn-Sb, 5wt% Sb | 250 | Atm. Pr. | Oxygen | 10 | 250 | 1.00E-03 | |
| 8* | Sn-Sb, 5wt% Sb | 250 | Atm. Pr. | Atm. | 10 | - | - | |
| 9* | Zn-Al, 5wt% Al | 250 | Atm. Pr. | Atm. | 10 | 250 | 1.00E-03 | |

| Ex. No. | 2^{nd} Anneal: Oxidizing Atm. | | 3^{rd} Anneal: Reducing Atm. | | | | Surface Res. (Ω/□) | Trans. (%) |
|---|---|---|---|---|---|---|---|---|
| | Atm. | Time , min | Tcm. (°C) | Pr. (Pa) | Atm. | Time , min | | |
| 2 | O₂ | 30 | - | - | - | - | 2600 | 97 |
| 3 | O₂ | 60 | - | - | - | - | 1900 | 89 |
| 4 | N₂, O₂ | 30 | - | - | - | - | 2400 | 93 |
| 5 | Atm. | 10 | - | - | - | - | 82 | 85 |
| 6 | Atm. | 120 | - | - | - | - | 70 | 94 |
| 7 | Atm. | 60 | - | - | - | - | 100 | 91 |
| 8 | Atm. | 120 | - | - | - | - | 219 | 95 |
| 9 | Atm. | 60 | - | - | - | - | 75 | 94 |
| 10 | Atm. | 120 | - | - | - | - | 80 | 98 |
| 11 | Atm. | 120 | - | - | - | - | 250 | 80 |
| 12 | Atm. | 120 | - | - | CO | - | 260 | 98 |
| 13 | H₂O Vapor | 30 | 230 | Atm. Pr. | N₂, H₂ | 30 | 123 | 98 |
| 14 | O₂ | 30 | 230 | Atm. Pr. | CO | 30 | 154 | 80 |
| 15 | O₂ | 30 | 230 | Atm. Pr. | Methanol | 30 | 104 | 98 |
| 16 | H₂O Vapor | 30 | 230 | 1.00E-03 | Atm. | 30 | 150 | 98 |
| 17 | O₂ | 30 | 230 | 1.00E-03 | Atm. | 30 | 176 | 80 |
| 18 | O₂ | 30 | 230 | 1.00E-03 | CO | 30 | 101 | 98 |
| 19 | Atm. | 10 | - | - | - | - | 95 | 91 |
| 20 | Atm. | 120 | - | - | - | - | 200 | 94 |
| 21 | Atm. | 60 | - | - | - | - | 120 | 98 |
| 22 | Atm. | 120 | - | - | - | - | 230 | 94 |
| 23 | Atm. | 60 | - | - | - | - | 260 | 91 |
| 24 | Atm. | 120 | - | - | - | - | 250 | 94 |
| 25 | Atm. | 120 | - | - | - | - | 1200 | 89 |
| 26 | Atm. | 120 | - | - | - | - | 2000 | 88 |
| 27 | H₂O Vapor | 30 | 230 | Atm. Pr. | N₂, H₂ | 30 | 190 | 92 |
| 28 | O₂ | 30 | 230 | Atm. Pr. | CO | 30 | 1600 | 93 |
| 29 | O₂ | 30 | 230 | Atm. Pr. | Methanol | 30 | 1700 | 92 |
| 30 | H₂O Vapor | 30 | 230 | 1.00E-03 | Atm. | 30 | 160 | 94 |
| 31 | O₂ | 30 | 230 | 1.00E-03 | Atm. | 30 | 1800 | 91 |
| 32 | O₂ | 30 | 230 | 1.00E-03 | CO | 30 | 2000 | 95 |
| 33 | Atm. | 10 | - | - | - | - | 7000 | 87 |
| 34 | Atm. | 120 | - | - | - | - | 6200 | 90 |
| 35 | Atm. | 60 | - | - | - | - | 3400 | 92 |
| 36 | Atm. | 120 | - | - | - | - | 3800 | 88 |
| 37 | H₂O Vapor | 30 | 230 | Atm. Pr. | N₂, H2 | 30 | 6000 | 95 |
| 38 | O₂ | 30 | 230 | Atm. Pr. | CO | 30 | 7000 | 96 |
| 39 | O₂ | 30 | 230 | 1.00E-03 | Atm. | 30 | 9000 | 95 |
| 40 | Atm. | 10 | - | - | - | - | 2500 | 93 |
| 41 | Atm. | 120 | - | - | - | - | 7000 | 94 |
| 42 | Atm. | 60 | - | - | - | - | 4000 | 89 |
| 43 | Atm. | 120 | - | - | - | - | 8300 | 93 |
| 44 | H₂O Vapor | 30 | 230 | Atm. Pr. | N₂, H₂ | 30 | 3200 | 91 |
| 45 | O₂ | 30 | 230 | Atm. Pr. | CO | 30 | 7000 | 90 |
| 46 | O₂ | 30 | 230 | 1.00E-03 | Atm. | 30 | 9000 | 89 |
| 3* | - | - | - | - | - | - | 880 | 50 |
| 4* | Atm. | 120 | - | - | - | - | 40000 | 94 |
| 5* | Atm. | 60 | - | - | - | - | 32000 | 93 |
| 6* | - | - | - | - | - | - | 34000 | 55 |
| 7* | CO | 30 | - | - | - | - | 620000 | 91 |
| 8* | - | - | - | - | - | - | 30000 | 45 |
| 9* | O₂ | 30 | - | - | - | - | 57000 | 89 |

The following conclusions can be obtained by the analysis of the data listed in the foregoing Table 1.

In the case of Examples 2 to 4 in which metallic In fine particles were used, each of the resulting films was found to have an excellent transmittance (%; Trans.) and a surface resistance (Ω/□; Surface Res.) of one to two figures larger than that observed for the films produced using the fine particles of In-Sn alloys. However, these films were found to be sufficient for putting into practical use. The films obtained using metallic In fine particles showed such high surface resistances since the ionized Sn donors never took part in the electrical conduction.

In the case of Examples 5 to 18 wherein In-Sn alloy fine particles were used, when each film was prepared by first firing a coated film-forming layer in an atmosphere which never caused any oxidation, then firing the layer in an oxidizing atmosphere and thereafter optionally firing the same in a reducing atmosphere, each of the resulting films showed a quite low surface resistance and a very high transmittance.

In the case of Examples 19 to 32 wherein In-Zn alloy fine particles were used, each of the resulting films was found to have a surface resistance almost identical to or slightly higher than that observed for the film produced using fine particles of In-Sn system. However, they were films excellent in the etching ability as compared with the films prepared from In, In-Sn and Sn-Sb systems. When each of the films obtained in these Examples was etched with oxalic acid (available from KANTO CHEMICAL Co., Ltd. under the trade name of ITO-06N), the etching rate thereof was found to be 3 to 4 nm/sec. On the other hand, the etching rates observed for the films prepared in Examples 5 to 8 were found to be a level only on the order of 0.1 to 0.2 nm/sec. From the foregoing, it was found that the films obtained from In-Zn systems were excellent in the processability.

In the case of Examples 33 to 39 wherein Sn-Sb alloy fine particles were used, each of the resulting films was found to have a high surface resistance, while it was excellent in the heat stability and chemical stability. These films were not etched at all even when they were immersed in aqua regia. Furthermore, these films never showed any change in the surface resistance even after they were additionally fired at a temperature of 600°C.

In the case of Examples 40 to 46 in which Zn-Al alloy fine particles were used, the surface resistances of the resulting films were found to be one figure higher than those observed for the films produced from In-Sn systems.

From the results obtained in the foregoing Examples, it would be concluded that the foregoing metal or alloy fine particles as starting materials can be treated according to the firing processes of the present invention to thus form various kinds of transparent conductive films which can appropriately be selected depending on a variety of intended purposes.

In the case of Comparative Examples 3 to 9 which make use of fine particles of metallic In, an In-Sn alloy, an Sn-Sb alloy and a Zn-Al alloy, the film prepared by firing only in a vacuum atmosphere (Comp. Ex. 3) had a low surface resistance, while it had only a low transmittance. In the case of Comparative Examples 4, 5, 6, 8 and 9 wherein the films were fired only in an oxidizing atmosphere, the transmission characteristics of the resulting films were increasingly improved as a function of the firing time, but the resistance values of the films were considerably deteriorated since the oxidation proceeded within the films as the firing time increased. Moreover, in the case of Comparative Example 7 in which the film-forming coated layer was first fired in an oxidizing atmosphere and then in a reducing atmosphere, the resulting film was excellent in the transmittance, but the surface resistance thereof was found to be quite high.

### Industrial Applicability

The present invention would permit the formation of a transparent conductive film having a low resistance and a high transmittance while making use of a low temperature firing process and therefore, the resulting transparent conductive film can be used in a variety of electrical and electronic industries and useful as a transparent electrode usable in, for instance, display machinery and tools such as a flat panel display device as well as an antistatic film and an electromagnetic wave-shielding film applied onto the display surface.

## Claims

1. A method for forming a transparent conductive film, comprising the steps of applying, onto a base material, a dispersion containing fine particles of a metal or alloy selected from the group consisting of indium, indium-tin alloy, indium-zinc alloy, tin-antimony alloy, and zinc-aluminum alloy to form a coated layer; firing the coated layer in an atmosphere which never undergoes any oxidation of the foregoing metal or alloy and which is selected from the group consisting of a vacuum atmosphere carried out at a pressure on the order of about 10⁻⁵ to 10³ Pa, an inert gas atmosphere and a reducing atmosphere; and subsequently firing the layer in an oxidizing atmosphere to thus form a transparent conductive film.

2. The method for forming a transparent conductive film as set forth in claim 1 wherein the method further comprises the step of firing the coated layer in a reducing atmosphere or a vacuum atmosphere after the firing step carried out in the oxidizing atmosphere.

3. The method for forming a transparent conductive film as set forth in claim 1 or 2, wherein the inert gas atmosphere is one comprising at least one inert gas selected from the group consisting of rare gases, carbon dioxide gas and nitrogen gas and the reducing atmosphere is one comprising at least one reducing gas selected from the group consisting of hydrogen, carbon monoxide and lower alcohols.

4. The method for forming a transparent conductive film as set forth in claim 1 or 2, wherein the vacuum atmosphere comprises at least one inert gas selected from the group consisting of rare gases, carbon dioxide and nitrogen; at least one oxidizing gas selected from the group consisting of oxygen and water vapor; at least one reducing gas selected from the group consisting of hydrogen, carbon monoxide and lower alcohols; or a mixed gas comprising the inert gas and the oxidizing gas or the reducing gas.

5. The method for forming a transparent conductive film as set forth in any one of claims 1 to 4, wherein the oxidizing atmosphere comprises oxygen, water vapor, oxygen-containing gases or water vapor-containing gases.

6. The method for forming a transparent conductive film as set forth in any one of claims 1 to 5, wherein the metal fine particles and/or the alloy fine particles are those each comprising an organic compound adhered to the surroundings thereof.

## Patentansprüche

1. Verfahren zur Bildung eines transparenten leitfähigen Films, enthaltend als Schritte das Auftragen einer feine Partikel eines Metalls oder einer Legierung aus der Gruppe bestehend aus Indium, Indium-Zinn-Legierung, Indium-ZinkLegierung, Zinn-Antimon-Legierung und Zink-AluminiumLegierung enthaltenden Dispersion auf ein Grundmaterial, um eine Beschichtung zu bilden; das Brennen der Beschichtung in einer Atmosphäre, in der niemals eine Oxidation des vorgenannten Metalls oder der Legierung stattfindet und die ausgewählt ist aus der Gruppe bestehend aus einer mit einem Druck in der Grössenordnung von ca. 10⁻⁵ bis 10³ Pa hergestellten Vakuumatmosphäre, einer Inertgasatmosphäre und einer Reduktionsatmosphäre; und das nachfolgende Brennen der Beschichtung in einer Oxidationsatmosphäre, um so einen transparenten leitfähigen Film zu bilden.

2. Verfahren zur Bildung eines transparenten leitfähigen Films nach Anspruch 1, wobei das Verfahren als weiteren Schritt nach dem in der Oxidationsatmosphäre durchgeführten Brennschritt das Brennen der Beschichtung in einer Reduktionsatmosphäre oder einer Vakuumatmosphäre beinhaltet.

3. Verfahren zur Bildung eines transparenten leitfähigen Films nach Anspruch 1 oder 2, wobei die Inertgasatmosphäre eine Atmosphäre ist, die mindestens ein aus der Gruppe bestehend aus Edelgasen, Kohlendioxidgas und Stickstoffgas ausgewähltes Inertgas enthält und die Reduktionsatmosphäre eine Atmosphäre ist, die mindestens ein aus der Gruppe bestehend aus Wasserstoff, Kohlenmonoxid und niederen Alkoholen ausgewähltes Reduktionsgas enthält.

4. Verfahren zur Bildung eines transparenten leitfähigen Films nach Anspruch 1 oder 2, wobei die Vakuumatmosphäre mindestens ein aus der Gruppe bestehend aus Edelgasen, Kohlendioxid und Stickstoff ausgewähltes Inertgas; mindestens ein aus der Gruppe bestehend aus Sauerstoff und Wasserdampf ausgewähltes Oxidationsgas; mindestens ein aus der Gruppe bestehend aus Wasserstoff, Kohlenmonoxid und niederen Alkoholen ausgewähltes Reduktionsgas; oder ein gemischtes Gas enthält, das das Inertgas und das Oxidationsgas oder das Reduktionsgas enthält.

5. Verfahren zur Bildung eines transparenten leitfähigen Films nach einem der Ansprüche 1 bis 4, wobei die Oxidationsatmosphäre Sauerstoff, Wasserdampf, sauerstoffhaltige Gase oder wasserdampfhaltige Gase enthält.

6. Verfahren zur Bildung eines transparenten leitfähigen Films nach einem der Ansprüche 1 bis 5, wobei die Metall-Feinpartikel und/oder die Legierungs-Feinpartikel jene mit jeweils einer in ihrer Peripherie anhaftenden organischen Verbindung sind.

## Revendications

1. Procédé de formation d'un film conducteur transparent, comprenant les étapes consistant à appliquer, sur un matériau de base, une dispersion contenant des particules fines d'un métal ou alliage choisi parmi le groupe comprenant l'indium, l'alliage d'indium-étain, l'alliage d'indium-zinc, l'alliage d'étain-antimoine et l'alliage de zinc-aluminium afin de former une couche de revêtement; à faire cuire la couche de revêtement dans une atmosphère qui ne subit jamais une oxydation du métal ou de l'alliage précité et qui est choisie parmi le groupe comprenant une atmosphère de vide mise en oeuvre à une pression de l'ordre d'env. 10⁻⁵ à 10³ Pa, une atmosphère de gaz inerte et une atmosphère réductrice; et à faire cuire ensuite la couche dans une atmosphère oxydante afin de former ainsi un film conducteur transparent.

2. Procédé de formation d'un film transparent conducteur selon la revendication 1, où le procédé comprend en outre l'étape consistant à faire cuire la couche de revêtement dans une atmosphère réductrice ou une atmosphère de vide après l'étape de la cuisson mise en oeuvre dans l'atmosphère oxydante.

3. Procédé de formation d'un film transparent conducteur selon la revendication 1 ou 2, où l'atmosphère de gaz inerte est une atmosphère comprenant au moins un gaz inerte choisi parmi le groupe comprenant les gaz rares, le gaz de dioxyde de carbone et le gaz de nitrogène et l'atmosphère réductrice est une atmosphère comprenant au moins un gaz réducteur choisi parmi le groupe comprenant l'hydrogène, le monoxyde de carbone et les alcools inférieurs.

4. Procédé de formation d'un film transparent conducteur selon la revendication 1 ou 2, où l'atmosphère de vide comprend au moins un gaz inerte choisi parmi le groupe comprenant les gaz rares, le dioxyde de carbone et le nitrogène; au moins un gaz oxydant choisi parmi le groupe comprenant l'oxygène et la vapeur d'eau; au moins un gaz réducteur choisi parmi le groupe comprenant l'hydrogène, le monoxyde de carbone et les alcools inférieurs; ou un gaz mélangé comprenant le gaz inerte et le gaz oxydant ou le gaz réducteur.

5. Procédé de formation d'un film transparent conducteur selon l'une quelconque des revendications 1 à 4, où l'atmosphère oxydante comprend l'oxygène, la vapeur d'eau, des gaz contenant de l'oxygène ou des gaz contenant de la vapeur d'eau.

6. Procédé de formation d'un film transparent conducteur selon l'une quelconque des revendications 1 à 5, où les particules fines métalliques et/ou les particules fines de l'alliage sont celles comprenant chacune un composé organique adhérant à l'extérieur.
